# EUROPÄISCHE PATENTSCHRIFT

(11) **EP 2 960 664 B1**
(45) Veröffentlichungstag und Bekanntmachung des Hinweises auf die Patenterteilung: **01.05.2019**
(21) Anmeldenummer: 14173727.0
(22) Anmeldetag: 24.06.2014
(51) Int. Cl.: G01R 21/06

(54) **System zur Erfassung von Leistungen und Energiemengen in Leitern**
System for detecting powers and amounts of energy in conductors
Système d'enregistrement de puissances et de quantités d'énergie dans des conducteurs

(43) Veröffentlichungstag der Anmeldung: 30.12.2015
(73) Patentinhaber: SYCOMP Electronic GmbH, 92507 Nabburg (DE)
(72) Erfinder: Hecht, Matthias, 85579 Neubiberg (DE); Karalis, Evangelos, 80992 München (DE)
(74) Vertreter: 2s-ip Schramm Schneider Bertagnoll Patent- und Rechtsanwälte Part mbB

(56) Entgegenhaltungen:
- EP-A1- 2 241 898
- WO-A2-2011/141938
- GB-A- 2 452 989
- GB-A- 2 506 135
- US-A1- 2007 069 715
- US-A1- 2008 079 437

## Beschreibung

### Technisches Gebiet

Die Erfindung betrifft ein System zur Erfassung von Leistungen und Energiemengen, die in Leitern fließen, die an einen Niederspannungsverteiler angeschlossen sind.

Um die Nachfrage an Strom z. B. in privaten Haushalten der jeweils zur Verfügung stehenden Energiemenge zumindest etwas anzugleichen, können Anreizsysteme helfen. Durch variablere Stromtarife, die die Angebots- und Nachfragesituation am Strommarkt für den Einzelverbraucher transparent machen, lohnt es sich für die Endverbraucher ihr Verhalten anzupassen. Aus Sicht der Energieversorgungsunternehmen (EVU) dienen die sogenannten "Smart Meter" dazu, den Stromverbrauch eines Kunden nicht nur als Gesamtverbrauch über ein Jahr zu erfassen, sondern eine sekundengenaue Aufzeichnung zu ermöglichen. Aus Sicht der EVU sind diese Geräte die notwendige Voraussetzung zu entsprechenden Tarifmodellen.

Auf Seiten der Verbraucher stellt ein "Smart Meter" des Standes der Technik allerdings nur einen, wenn auch zeitlich sehr gut aufgelösten Verbrauchswert zur Verfügung, und zwar den Gesamtverbrauch für die Zählerstelle.

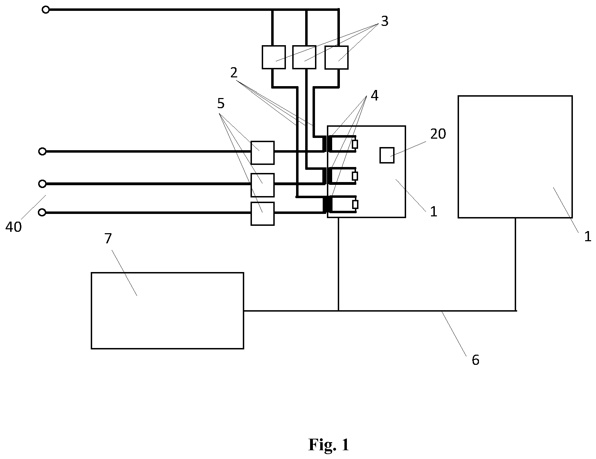

Ein Modul zur Erfassung des Stroms, den individuelle Verbraucher, die an einen Niederspannungsverteiler angeschlossen sind, verbrauchen, ist z.B. in EP 2282321 A1 beschrieben. Die prinzipielle Funktionsweise dieses Moduls ist entsprechend der Anordnung in Fig. 1. Ein Strommessmodul 1 erfasst jeweils einen Strom 2, der zu einem an den Niederspannungsverteiler angeschlossenen Verbraucher 3 führt. Jeder Verbraucher 3 ist dabei jeweils an als ein modulares Reiheneinbaugerät 5 ausgebildetes Schalt- und Schutzgerät angeschlossen. Dieses Reiheneinbaugerät 5 ist z.B. ein Leitungsschutzschalter, Fehlerstromschutzschalter, eine Überspannungs- oder Überstromschutzeinrichtung. Die Erfassung des Stroms 2 erfolgt dabei galvanisch getrennt über einen geeigneten Stromsensor 4.

Das Strommessmodul 1 ist dabei in seinen Abmessungen so dimensioniert, dass seine Breite die Breite des Reiheneinbaugeräts nicht übersteigt. Dann nämlich können die Strommessmodule im Niederspannungsverteiler in Reihe mit den entsprechenden Reiheneinbaugeräten angeordnet werden. Die Strommessmodule 1 umfassen jeweils einen eigenen Prozessor und sind über eine gemeinsame Kommunikationsverbindung 6 miteinander und mit einer zentralen Funktionseinheit 7 verbunden. Über diese Kommunikationsverbindung 6 werden Daten der Strommessmodule 1 zur zentralen Funktionseinheit 7 übertragen. In dieser zentralen Funktionseinheit 7 erfolgt die Aufbereitung der Daten. Die Daten der Strommessmodule 1 können dem Anwender dabei in Form von Reports oder anderen Auswertungen zur Verfügung gestellt werden. Ebenfalls wird eine langzeitige Speicherung der Daten in der zentralen Funktionseinheit 7 oder eine Weiterleitung der Daten an weitere Datenerfassungssysteme beschrieben.

Die Auswertung der Daten dient dem Anwender für verschiedene Zwecke, z.B. der Optimierung seines Energieverbrauchs nach verschiedenen Kriterien oder der korrekten Zuordnung der Energiekosten zu verschiedenen, untergeordneten Einheiten.

Da die Erfassung der Ströme 2 in den Strommessmodulen 1 galvanisch getrennt erfolgt, kann die Elektronik in den Strommessmodulen 1 selbst auf die Anforderungen von Schutzkleinspannung ausgelegt werden. Dadurch können Platz- und Kostenvorteile gegenüber einer Messtechnik auf Niederspannungsniveau (z.B. 240V) realisiert werden.

Allerdings können die Strommessmodule 1 nur den Effektivwert des Stroms 2 messen. Dieser Effektivwert des Stroms 2 ist aber nur bei einem einfachen linearen Verbraucher 3 (Ohmscher Widerstand) proportional zur Wirkleistung, die der Verbraucher verbraucht. Für Verbraucher 3, die eine Strom- Spannungs- Charakteristik mit entweder einer Verschiebe- oder einer Verzerrungsblindleistung oder beidem aufweisen, gilt diese Proportionalität nicht. Das bedeutet, dass es mit dieser Messanordnung für diese Verbraucher nicht möglich ist, die Wirkleistung der Verbraucher korrekt zu erfassen. Durch die Annahme der Proportionalität von Effektivwert des Stromes und Wirkleistung können Fehler entstehen, die in der Praxis erheblich größer als die Messtoleranz des Strommessmoduls 1 sind.

US 2008/0079437A1 betrifft ein Erfassungssystem gemäß dem Oberbegriff des Anspruchs 1.

### Kurzbeschreibung der Erfindung

Aufgabe der Erfindung ist es, den beschriebenen Nachteil der Strommessmodule 1 zumindest zum Teil zu eliminieren, ohne dabei den Vorteil der kompakten und preisgünstigen Bauweise aufzugeben.

Diese Aufgabe wird durch das Erfassungssystem gemäß Anspruch 1 gelöst. Vorteilhafte Weiterbildungen sind in den abhängigen Ansprüchen definiert.

Bereitgestellt wird demnach ein Modul als Teil des erfindungsgemäßen Erfassungssystems für Leistungen oder Energiemengen, die durch Leiter übertragen werden, welche an einem Niederspannungsverteiler angeschlossen sind, wobei das Modul ausgestaltet ist, eine Anzahl von Strömen zu bestimmen, die durch eine Anzahl von Leitern fließen, wobei die Anzahl von Leitern an eine Anzahl von Reiheneinbaugeräten, die in dem Niederspannungsverteiler angeordnet sind, angeschlossen ist, und unter Verwendung eines bereitgestellten Spanungssignals, das aus mindestens einer Eingangsspannung auf Niederspannungsniveau erzeugt wird, Signale zu erzeugen, die repräsentativ für die Leistungen oder die Energiemengen sind, die jeweils durch die Anzahl von Leitern übertragen werden, wobei das Modul ausgestaltet ist, in dem Niederspannungsverteiler angeordnet zu werden, und zwar in Längsrichtung, insbesondere unmittelbar oberhalb oder unterhalb, der Anzahl von Reiheneinbaugeräten.

Die Leistungen können die Wirk-, Blind- oder Scheinleistung sein.

Vorteilhafte Weiterbildungen der Erfindungen können wie folgt sein.

Das Modul kann so dimensioniert sein, dass es im Wesentlichen der Breite der entsprechenden Anzahl von Reiheneinbaugeräten in Montageposition im Niederspannungsverteiler entspricht.

Dies heißt, dass das Modul im Niederspannungsverteiler oberhalb oder unterhalb derjenigen Reiheneinbaugeräte angeordnet werden kann, deren Ströme es erfasst. Die Anzahl von Leitern und die Anzahl von Reiheneinbaugeräten kann jeweils eins sein.

Dies heißt, dass jedes Modul die Leistung oder die Energiemenge erfasst, die durch genau einen Leiter übertragen wird, der seinerseits an genau ein Reiheneinbaugerät angeschlossen ist. In diesem Fall hat das Modul im Wesentlichen die (standardisierte) Breite des Reiheneinbaugeräts.

Die Anzahl von Leitern und die Anzahl von Reiheneinbaugeräten kann jeweils größer eins sein.

Dies heißt, dass jedes Modul mehrere Leistungen oder Energiemengen separat erfasst, wobei jede der Leistungen oder Energiemengen durch jeweils einen Leiter übertragen wird. Die Leiter sind ihrerseits jeweils an genau ein Reiheneinbaugerät angeschlossen. In diesem Fall hat das Modul im Wesentlichen die (standardisierte) Breite der Anzahl von Reiheneinbaugeräten zusammen. Hierbei ist natürlich vorausgesetzt, dass die Reiheneinbaugeräte im Niederspannungsverteiler nebeneinander angeordnet sind.

In jedem Modul kann eine Anzahl von Stromsensoren zur Ermittlung der Anzahl von Strömen vorgesehen sein, wobei als Stromsensoren insbesondere induktive Übertrager, Hall-Elemente, Flux-Gates und/oder magnetoresistive Elemente eingesetzt werden.

Des Weiteren bereitgestellt wird eine Funktionseinheit als Teil eines erfindungsgemäßen Erfassungssystems für Leistungen oder Energiemengen, die durch Leiter übertragen werden, welche an einem Niederspannungsverteiler angeschlossen sind, wobei die Funktionseinheit ausgestaltet ist,
zumindest ein Signal, das anhand einer eineindeutigen Abbildungsvorschrift aus mindestens einer Eingangsspannung auf Niederspannungsniveau erzeugt wird, zumindest einem Modul gemäß der Erfindung bereitzustellen, und
von dem zumindest einen Modul Signale zu empfangen, die repräsentativ für die Leistungen oder Energiemengen sind.

Die Funktionseinheit kann ausgestaltet sein, ein Signal, welches repräsentativ für die Leistung oder die Energiemenge ist, nach außen bereitzustellen, z.B. zur weiteren Verwendung für den Anwender oder für das EVU.

Hierbei kann die Funktionseinheit so ausgestaltet sein, dass sie eine Schnittstelle zur Verfügung stellt, über die Daten der Module zu den Leistungen oder Energiemengen, die durch die Leiter übertragen werden, abgerufen und analysiert werden können.

Die Funktionseinheit kann als ein einzelnes Gerät realisiert sein. Dann ist sie besonders kompakt. Es kann aber auch vorgesehen sein, dass die Funktionseinheit mehrere getrennte Geräte umfasst. Die Funktionseinheit kann so ausgestaltet sein, dass sie auch in dem Niederspannungsverteiler angeordnet werden kann.

Erfindungsgemäß bereitgestellt wird ein Erfassungssystem für Leistungen oder Energiemengen, die durch Leiter übertragen werden, welche an einem Niederspannungsverteiler angeschlossen sind, umfassend: Zwei Module gemäß obiger Ausführung und zumindest eine Funktionseinheit gemäß obiger Ausführung.

Das Erfassungssystem ist vorteilhafterweise dazu ausgestaltet, ganz oder teilweise in dem Niederspannungsverteiler angeordnet zu werden.

Das Erfassungssystem kann des Weiteren so ausgestaltet sein, dass die Bereitstellung des zumindest einen Signals auf einer Messspannungsversorgung über eine analoge Leitung oder über eine digitale Schnittstelle erfolgt.

Das Erfassungssystem ist des Weiteren so ausgestaltet, dass eine Datenverbindung und eine Messspannungsversorgung vorgesehen sind, welche die Funktionseinheit und das zumindest eine Modul miteinander verbinden, wobei die Datenverbindung und die Messspannungsversorgung ganz über Flachbandkabel realisiert ist.

Das Erfassungssystem kann so ausgestaltet sein, dass in dem zumindest einen Modul jedem gemessenen Strom eine von mehreren möglichen Spannungen zugeordnet ist. Die eine von mehreren möglichen Spannungen kann die Spannung einer der drei Phasenanschlüsse des Drehstromniederspannungsnetzes sein.

Das Erfassungssystem kann so ausgestaltet sein, dass die Zuordnung aus mehreren möglichen Spannungen durch eine Einstellung in Software in dem zumindest einen Modul oder anhand eines Algorithmus automatisch oder durch eine elektromechanische Kontaktherstellung manuell erfolgt.

Das Erfassungssystem kann so ausgestaltet sein, dass in jeweils einem Modul nur eine aus mehreren möglichen Spannungen für alle Leiter, für das Modul die jeweilige Leistung bestimmt, ausgewählt werden kann.

Das Erfassungssystem kann so ausgestaltet sein, dass die Funktionseinheit allen Modulen ein und dasselbe Signal bereitstellt.

Dann wird für eine Installation des Erfassungssystems im Niederspannungsverteiler prinzipiell lediglich eine einzige Funktionseinheit benötigt, welche dann mehrere bzw. alle Module mit dem Signal versorgt. Dies bringt eine Platz- und Installationsersparnis für das Erfassungssystem mit sich.

Die Eingangsspannung kann von zumindest einem der Phasenanschlüsse des Niederspannungsnetzes abgeleitet werden.

Über einen induktiven Übertrager oder über einen Widerstandsspannungsteiler kann ein zur Eingangsspannung proportionales Kleinspannungssignal erzeugt werden, aus welchem das Signal abgeleitet wird.

Die Erfindung ermöglicht es, das Verbrauchsverhalten im eigenen Haushalt oder in der Firma zu optimieren. Denn mit einer detaillierten Aufzeichnung des Verbrauchs der einzelnen Abnehmer und einer anschließenden Analyse ist es möglich, den Energieverbrauch zu optimieren. Weiterhin kann es damit ermöglicht werden, z.B. einzelne Verbraucher in einer Firma oder einem Haushalt dynamisch aufgrund der aktuellen Verbrauchs- und Preissituation zu- oder abzuschalten.

Um diese Funktionen zu unterstützen, wird erfindungsgemäß eine detaillierte Verbrauchsmessung bereitgestellt.

Die erfindungsgemäß kompakte Bauform ermöglicht es, zumindest die Module des Systems im Niederspannungsverteiler der Haushalte und Firmen anzuordnen, also in dem Verteilerkasten selbst unterzubringen. Hier werden aus der Zuleitung des EVUs die einzelnen Teilnetze abgezweigt. Jedes Teilnetz wird dabei in der Regel mit einem Leitungsschutzschalter, zusätzlich manchmal auch mit einem Fehlerstromschutzschalter oder Überspannungs- und Überstromschutzeinrichtungen abgesichert. Diese Schalter und Einrichtungen, die im Niederspannungsverteiler reihenweise angeordnet sind, werden im Folgenden als Reiheneinbaugeräte bezeichnet.

Die Erfindung bietet ferner eine preisgünstige Möglichkeit, viele Messstellen einzurichten, indem sowohl die Kosten für die neu zu installierenden Module als auch die Kosten für die Installation und Verkabelung der Module verhältnismäßig gering gehalten werden können. Denn auch bei der Nachrüstung von bereits vorhandenen Installationen können die Module direkt mit den oben erwähnten Reiheneinbaugeräten kombiniert werden. Diese Geräte sind gut standardisiert. Sie haben definierte Außenmaße bei denen die Breiten in einem Raster festgelegt sind und werden auf einer Hutschiene im Niederspannungsverteiler montiert. Auch die Abstände zwischen den Reihen sind in der Regel einheitlich.

### Kurzbeschreibung der Figuren

Die Erfindung sowie Ausführungsbeispiele der Erfindung werden anhand der Zeichnung näher beschrieben. In der Zeichnung zeigen
Fig. 1 ein Leistungserfassungssystem des Standes der Technik;
Fig. 2 eine erste Ausführungsform der Erfindung;
Fig. 3 die Anordnung eines erfindungsgemäßen Systems im in einem Niederspannungsverteiler;
Fig. 4 ein Prinzipschaltbild der Leistungsmessung; und
Fig. 5 den Aufbau eines Moduls.

### Detaillierte Beschreibung

Die vorliegende Erfindung befasst sich mit einem System und den Komponenten dieses Systems zur Erfassung der Leistung oder der Energie in Teilnetzen, die an einen Niederspannungsverteiler angeschlossen sind. Ein Teilnetz umfasst einen Stromleiter 2, der an ein Reiheneinbaugerät 5 angeschlossen ist, und (mindestens) einen Verbraucher 3, der an den Stromleiter 2 angeschlossen ist, Der Strom I durch den Stromleiter 2 fließt also durch das Reiheneinbaugerät 5 und den Verbraucher 3.

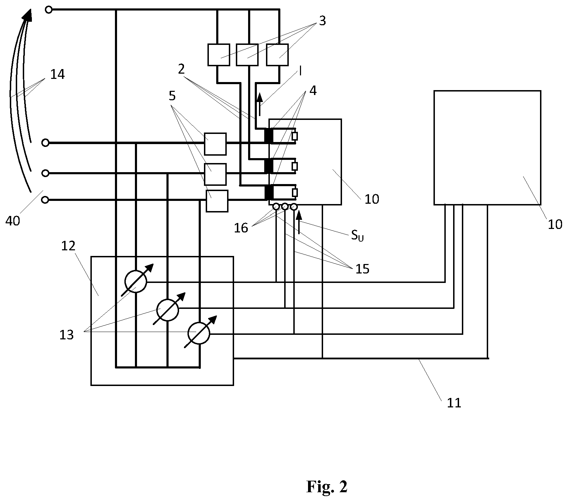

Beim Ausführungsbeispiel der Erfindung gemäß Fig. 2 umfasst das Erfassungssystem eine zentrale Funktionseinheit 12 und zwei Module 10. Die beiden Module 10 sind über eine Datenverbindung 11 miteinander und mit einer Funktionseinheit 12 verbunden. Des Weiteren vorgesehen ist eine Messspannungsversorgung 15, über welche den Modulen 10 wenigstens ein Spanungssignal bereitgestellt wird.

Die Module 10 sind so ausgestaltet, dass sie die Leistung und den Energieverbrauch in jedem der Teilnetze, das jeweils an ein Reiheneinbaugerät entsprechend obiger Beschreibung angeschlossen ist, erfassen. Da die Installation im Niederspannungsverteiler möglich ist, ohne die Abstände zwischen den Leitungsschutzschaltern zu verändern, kann eine bereits vorhandene Installation einfach durch ein oder mehrere Module 10 ergänzt werden.

Beim Ausführungsbeispiel der Fig. 2 ist das linke Modul 10 ausgestaltet, die Ströme dreier Stromleiter 2 getrennt zu erfassen. Das Modul 10 umfasst hierzu drei Stromsensoren 4. Die Anzahl von Leitern, die Anzahl von Strömen und die Anzahl von Reiheneinbaugeräten pro Modul 10 ist jeweils drei.

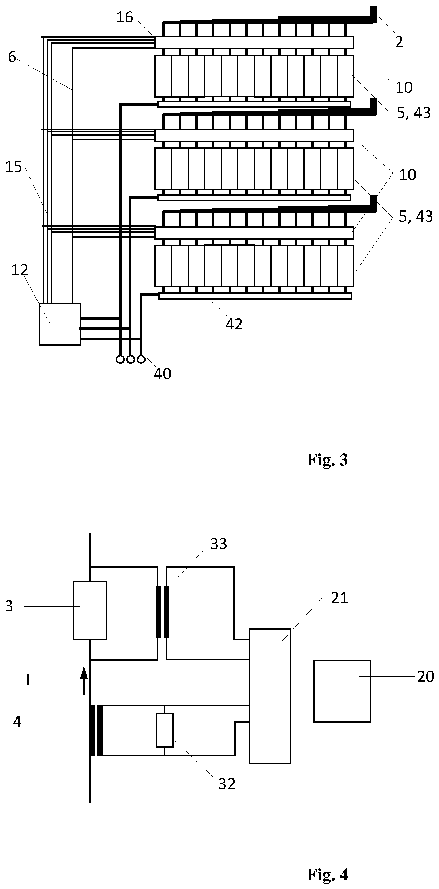

Fig. 3 stellt den exemplarischen Aufbau eines Niederspannungsverteilers mit 36 Teilnetzen 2 dar: 36 Leitungsschutzschalter 43 sind in drei Reihen zu jeweils zwölf Reiheneinbaugeräten 5 montiert. Die drei Phasen 40 (L1, L2, L3) der Niederspannung sind auf die drei Reihen der Leitungsschutzschalter 43 aufgeteilt. Auf der Unterseite der Leitungsschutzschalter 43 sind diese alle über eine Stromschiene 42 mit der einen der drei Phasen verbunden.

Die Leiter 2 der einzelnen Teilnetze sind von der Oberseite der Leitungsschutzschalter 43 durch die Module 10 geführt. In diesem Beispiel sind die Module 10 so ausgelegt, dass jedes Modul zwölf einzelne Stromsensoren 4 hat, also zwölf Ströme I in zwölf Leitern 2 einzeln erfassen kann. Die Anzahl von Leitern, Strömen und Reiheneinbaugeräten pro Modul 10 ist also jeweils 12. Für den exemplarischen Niederspannungsverteiler werden also insgesamt drei Module 10 benötigt. Von den Modulen 10 verlaufen die Leiter 2 weiter, z.B. in einer Installation in Leerrohren, zu den Verbrauchern 3 in den jeweiligen Teilnetzen.

Der Nullleiter und der Schutzleiter sind jeweils auf Klemmen aufgelegt und verteilt. Dieser Teil der Installation ist hier nicht dargestellt.

Die Stromsensoren 4 in den Modulen 10 sind zur Erfassung der Ströme I in den durchgeführten Leitern 2 angebracht. Die Module 10 sind, wie bereits beschrieben, über die Datenverbindung 11 mit der Funktionseinheit 12 verbunden. Über diese kommunizieren die Module 10 mit der Funktionseinheit 12 und leiten die gemessenen Daten zur weiteren Aufbereitung weiter.

In der Erfindung stellt die Datenverbindung 11 eine Busstruktur dar, die einzelnen Teilnehmer, also die Module 10 und die Funktionseinheit 12 können also auf dem Physical Layer interagieren. Die gezielte Kommunikation zwischen den Modulen 10 und der Funktionseinheit 12 erfolgt auf Basis von Adressierungsmechanismen der Teilnehmer. Damit lässt sich das System durch das Hinzufügen weiterer Module erweitern.

Diese Busstruktur ist als durchgehendes Flachbandkabel realisiert. In einer weiteren Ausgestaltung der Erfindung werden die Module 10 zusätzlich über das Kabel der Datenverbindung oder ein weiteres Kabel mit Energie versorgt.

In einer weiteren Ausgestaltung der Erfindung stellt die zentrale Funktionseinheit 12 die Energie für die Module 10 zur Verfügung.

In einer weiteren Ausgestaltung der Erfindung ist jedes Modul 10 zur Messung der Leistung oder Energiemenge in genau einem Leiter, also in genau einem Teilnetz, vorgesehen. Dann beträgt die Anzahl von Strömen, Leitern und Reiheneinbaugeräten jeweils eins.

In einer weiteren Ausgestaltung der Erfindung ist jedes Modul 10, das zur Messung der Leistung oder Energiemenge in genau einem Teilnetz vorgesehen ist, im Wesentlichen maximal so breit wie die Standardbreite eines Reiheneinbaugeräts 5.

In einer weiteren Ausgestaltung der Erfindung sind die Module 10 zur Messung der Leistung oder der Energiemenge in mehreren Leitern 2, also mehreren Teilnetzen vorgesehen.

Dann ist ein Modul 10, das zur Messung der Leistung oder der Energiemenge in mehreren Leitern 2, also Teilnetzen, vorgesehen ist, im Wesentlichen maximal so breit wie die Standardbreite eines Reiheneinbaugeräts 5 multipliziert mit der Anzahl der Teilnetze, für die dieses Modul 10 vorgesehen ist.

Dann lassen sich die Module 10 besonders gut in einem Niederspannungsverteiler nebeneinander gereiht anordnen, und zwar in Längsrichtung oberhalb (oder unterhalb) der Reiheneinbaugeräte, deren Ströme sie erfassen. Die Module 10 können hierbei mit den Reiheneinbaugeräten 5 verklebt werden und/oder auf den Leitern, deren Ströme sie messen, fixiert werden oder mit einer anderen Methode gegen unzulässige mechanische Bewegung gesichert werden.

Wenn ein Modul 10 zur Messung der Leistungen aller Leiter in einer Reihe im Niederspannungsverteiler vorgesehen ist, kann die Breite des Moduls auch etwas größer als die Breite der entsprechenden Anzahl von Reiheneinbaugeräten sein, denn dann müssen ja nicht mehrere Module 10 in einer Reihe im Niederspannungsverteiler nebeneinander angeordnet werden.

Wie oben erwähnt, ist ein wesentlicher Aspekt die kleine Bauform der Module. Für die Strommessung bietet sich der beschriebene Aufbau deswegen an: Aufgrund der Strommessung mit einem galvanisch getrennten Stromsensor kann die gesamte Elektronik des Moduls 10 auf Kleinspannung (z.B. 42 Volt) ausgelegt werden. Einzig eine Isolation gegen den durchgeführten Leiter 2 ist erforderlich. Diese Isolation wird durch das Gehäuse des Moduls 10 gewährleistet.

Die Strommessung kann z.B. mit passiven induktiven Übertragern, mit einem Open-Loop-Stromsensor oder mit einem Closed-Loop-(Nullfluss-kompensierten) Stromsensor erfolgen.

Als Detektorelemente für die Stromsensoren 4 können z.B. Hall-Elemente, Flux Gates oder magnetoresistive Elemente verwendet werden.

Die Messung der Wirkleistung in einem Leiter 2 kann prinzipiell wie in Fig. 4 erfolgen. Der Strom I, der durch den Leiter 2 zum Verbraucher 3 fließt, wird z.B. mit einem Stromwandler 4 und einem Messshunt 32 in eine kleine proportionale Spannung umgewandelt. Diese Spannung wird von einem Analog-Digital-Wandler 21 in einen digitalen Wert für den Strom umgewandelt.

Die Niederspannung des Verbrauchers wird, z.B. mit einem Spannungswandler 33, in eine kleine proportionale Spannung umgewandelt. Auch diese Spannung wird von dem Analog-Digital-Wandler 21 in einen digitalen Wert für die Spannung umgewandelt. Diese beiden Spannungswerte werden z.B. in einem Prozessor 20 zu einem Leistungswert multipliziert und integriert.

Um die Schein-, Blind- und/oder Wirkleistung korrekt zu erfassen, können die Messwerte von Strom und Spannung entsprechend der vorliegenden Erfindung miteinander multipliziert werden.

In einer Ausgestaltung der Erfindung wird das Ergebnis dieser Multiplikation über eine ganzzahlige Anzahl von Perioden der Grundwelle des Stroms bzw. der Spannung integriert.

In einer Ausgestaltung der Erfindung wird das Ergebnis dieser Multiplikation über eine ausreichend große Zeit integriert, um den Fehler, der durch das unvollständige Integrieren einer Periode entsteht, unterhalb einer akzeptablen Fehlerschwelle zu halten.

In einer weiteren Ausgestaltung der Erfindung erfolgt die Berechnung der Leistungswerte durch das Ausführen einer dazu geeigneten Software in einer dazu geeigneten Ausführungseinheit.

In einer Ausgestaltung der Erfindung ist diese Einheit ein Mikrocontroller.

In einer weiteren Ausgestaltung der Erfindung ist diese Einheit ein Mikroprozessor.

In einer weiteren Ausgestaltung der Erfindung erfolgt die Berechnung der Leistung oder der Energiemenge in einer geeigneten digitalen Schaltung.

In einer weiteren Ausgestaltung der Erfindung wird die digitale Schaltung in mindestens einem IC mit programmierbarer Logik umgesetzt.

In einer weiteren Ausgestaltung der Erfindung werden die Strom- und Spannungswerte analog miteinander multipliziert und erst der analoge Leistungswert mit einem Analog-Digital-Wandler in einen digitalen Wert umgewandelt.

Eine einfache Umsetzung der Leistungsmessung bzw. der Energiemengenmessung nach dem oben beschriebenen Prinzip bedeutet, dass der jeweilige Leiter 2 eines jeden Teilnetzes an ein Modul 10 angeschlossen werden muss. Für jeden Leiter 2 müssen zusätzliche Klemmen und ein eigener Spannungswandler vorgesehen werden.

Wenn der Spannungswandler in das Modul 10 integriert ist, muss das Modul 10 für die Niederspannungsebene vorgesehen werden. Entsprechende Luft- und Kriechstrecken und gegebenenfalls weitere Schutzvorrichtungen verhindern zuverlässig, dass der Anwender vor einer Berührung der Niederspannung geschützt wird.

Wenn der Spannungswandler extern realisiert ist, muss in dem Niederspannungsverteiler dafür ein weiterer Platz vorhanden sein. Die Verkabelung der Teilnetze mit den Reihenanschlussgeräten 5 kann dann in der Regel nicht mehr wiederverwendet werden. Bei beengten Platzverhältnissen muss ein weiterer Niederspannungsverteiler vorgesehen werden.

Da es sich um Verbraucher in einem Niederspannungsnetzwerk handelt, kann der konstruktive Aufwand mit der vorliegenden Erfindung stark reduziert werden. In einem Niederspannungsnetzwerk gibt es grundsätzlich aufgrund der Stromerzeugung in Drehstromgeneratoren nur drei Phasen. Diese drei Phasen sind um 120° gegeneinander versetzt. Jedes Teilnetz ist an einer der drei Phasen angeschlossen.

Damit ist es ausreichend, wenn für jedes Modul 10, unabhängig von der Anzahl der Teilnetze, die mit dem Modul 10 erfasst werden sollen, die Spannungen der drei Phasen zur Verfügung stehen. Die Module 10 werden entsprechend der Busstruktur in der Datenverbindung 11 über eine gemeinsame Messspannungsversorgung 15 mit diesen drei Spannungen versorgt. Dabei können bei Installationen, in denen nicht alle drei Phasen benutzt werden, auch einzelne der drei Phasen nicht verwendet werden.

Die Messspannungsversorgung 15 für die Module 10 enthält dabei nicht die Niederspannung direkt sondern eine wesentlich kleinere Spannung, z.B. einen Spannungswert, der im Bereich der Schutzkleinspannung liegt. Diese Spannung steht kontinuierlich zur Verfügung und steht in einer eineindeutigen Relation zur ursprünglichen Niederspannung. Im einfachsten Fall ist diese Relation eine direkte Proportionalität. Durch die Verwendung dieser kleineren Spannung können die Themen des Personen- und Geräteschutzes für Niederspannungsgeräte in den Modulen 10 vermieden werden.

In einer weiteren Ausgestaltung der Erfindung wird als Messspannungsebene in der Messspannungsversorgung 15 eine Spannung Su kleiner als Schutzkleinspannung verwendet.

In einer Ausgestaltung der Erfindung wird die Messspannung über eine direkte Proportionalität aus der Niederspannung abgeleitet.

In einer Ausgestaltung der Erfindung enthält die Messspannungsversorgung 15 Spannungen für jede der drei Phasen des Niederspannungsdrehstroms.

In einer Ausgestaltung der Erfindung enthält die Messspannungsversorgung 15 nur für eine oder zwei Spannungen der drei Phasen des Niederspannungsdrehstroms eine entsprechende Spannung.

In einer Ausgestaltung der Erfindung werden die Spannung oder die Spannungen Su der Messspannungsversorgung 15 als Digitalsignale übertragen. In diesem Fall enthalten die Module keinen analogen Eingang sondern eine digitale Schnittstelle für die Spannungen. Bei der digitalen Übertragung sorgen Synchronisierungsmechanismen für eine Synchronisation des Spannungssignals Su und des Stromsignals zwischen Sender (Funktionseinheit 12) und Empfänger (Modul 10).

In einer weiteren Ausgestaltung der Erfindung enthält der Synchronisationsmechanismus mindestens eine Synchronisationsleitung (Hardware-Synchronisierung).

In einer weiteren Ausgestaltung der Erfindung nutzt der Synchronisationsmechanismus ein Synchronisationsprotokoll (Software-Synchronisierung)

In der Erfindung hat die Übertragung zwischen Sender (Funktionseinheit 12) und Empfänger (Modul 10) eine definierte, konstante Latenzzeit zur Synchronisation.

In einer weiteren Ausgestaltung der Erfindung ist die digitale Schnittstelle der Messspannungsversorgung 15 mit der Datenverbindung 11 zusammengefasst.

In einer weiteren Ausgestaltung der Erfindung enthalten die Module 10 eine Vorrichtung oder eine Rechenvorschrift, die es erlaubt, anhand der eineindeutigen Abbildungsvorschrift von der Spannung der Messspannungsversorgung 15 den Wert der zugehörigen Niederspannung für die Berechnung der Leistung zu berücksichtigen.

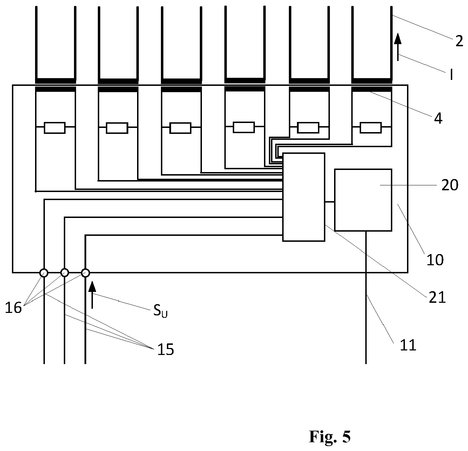

Fig. 5 zeigt ein Blockschaltbild eines Moduls 10 für sechs Teilnetze 2. In diesem Blockschaltbild ist ersichtlich, dass für die sechs Stromsensoren 4 nur drei Spannungseingänge 16 vorgesehen sind.

Damit aus den Strom- und Spannungseingängen korrekte Leistungswerte berechnet werden, wird jedem Stromsensor 4 innerhalb des Moduls 10 ein Spannungseingang 16 für das Spannungssignal Su zugeordnet. Dabei kann die Zuordnung auf verschiedene Arten erfolgen:
In einer Ausgestaltung der Erfindung erfolgt diese Zuordnung mittels Programmierung durch einen Bediener, der die Installation der Anlage kennt. Diese Zuordnung kann durch eine entsprechende Bedienereingabe bei der Installation durchgeführt werden. Durch eine entsprechende Funktion in der Software der zentralen Funktionseinheit 12, z.B. in Verbindung mit weiteren, mit der zentralen Funktionseinheit 12 über ein Datennetzwerk verbundenen Geräten, wird der Zuordnungswert an das Modul 10 übertragen.

In einer Ausgestaltung der Erfindung wird der Wert in einem nichtflüchtigen Datenspeicher im Modul 10 gespeichert und steht dann bei einer Reinitialisierung des Moduls 10 wieder zur Verfügung.

In einer Ausgestaltung der Erfindung wird der Wert nach jeder Reinitialisierung des Moduls 10 erneut von der zentralen Funktionseinheit 12 über ein Kommando in das Modul 10 übertragen.

In einer Ausgestaltung der Erfindung wird die Zuordnung mit Bedienelementen auf dem Modul 10 durchgeführt. Hier könnten z.B. Schalter, Taster oder Jumper verwendet werden.

In einer Ausgestaltung der Erfindung wird die Zuordnung durch einen Algorithmus ermittelt.

In einer Ausgestaltung der Erfindung ermittelt dieser Algorithmus die Phasenlage jeden Stroms in einem Stromsensor 4. Weiterhin ermittelt dieser Algorithmus die Phasenlage jeder Spannung an jedem Spannungseingang 16 und ordnet jedem Stromsensor 4 die Spannung zu, deren Phasenverschiebung am kleinsten gegenüber der Phasenlage des jeweiligen Stroms ist.

In einer Ausgestaltung der Erfindung sind die Module 10 jeweils nur für eine Spannung ausgelegt. In der Praxis sind die in einer Reihe nebeneinander liegenden Reiheneinbaugeräte 5, insbesondere wenn es sich um Leitungsschutzgeräte handelt, vielfach an die gleiche Phase angeschlossen, vgl. Fig. 3. Bei dieser Anordnung wird nur einer der Spannungseingange 16 zur Berechnung der Leistung für alle angeschlossenen Stromsensoren 4 ausgewählt.

In einer Ausgestaltung der Erfindung erfolgt die Auswahl des entsprechenden Spannungseingangs 16 mit einem elektromechanischen Kontaktelement.

In einer Ausgestaltung der Erfindung ist das Kontaktelement ein Schalter.

In einer weiteren Ausgestaltung der Erfindung ist das Kontaktelement ein Jumper.

In einer Ausgestaltung der Erfindung erfolgt die Auswahl des entsprechenden Spannungseingangs 16 mit einem elektronischen Schalter.

In einer Ausgestaltung der Erfindung erfolgt die Auswahl des entsprechenden Spannungseingangs durch den Bediener.

In einer Ausgestaltung der Erfindung erfolgt die Auswahl des entsprechenden Spannungseingangs durch einen entsprechenden Algorithmus.

Die Messspannungsversorgung 15 ist in der Funktionseinheit 12 realisiert.

Für die Messspannungsversorgung 15 benötigt die Funktionseinheit 12 einen Anschluss der Phasen des Niederspannungssystems.

In einer Ausgestaltung der Erfindung enthält die Funktionseinheit 12 Anschlüsse für alle drei Phasen des Niederspannungssystems.

In einer Ausgestaltung der Erfindung enthält die Funktionseinheit 12 nur Anschlüsse für ein oder zwei der drei Phasen des Niederspannungssystems.

In Installationen in denen nicht alle drei Phasen verwendet werden, können dabei einzelne Phasen auch weggelassen werden.

Die Funktionseinheit 12 wandelt die drei Phasen der Niederspannung über Messmittel 13 mit einer eineindeutigen Abbildungsfunktion (z.B. eine proportionale Abbildung) in die Spannungen der Messspannungsversorgung 15 um.

In einer Ausgestaltung der Erfindung wird bei der Umwandlung mindestens ein analoges Ausgangssignal erzeugt.

In einer Ausgestaltung der Erfindung erfolgt diese Umwandlung durch eine analoge Schaltung.

In einer Ausgestaltung der Erfindung enthält die analoge Schaltung einen Spannungsteiler.

In einer Ausgestaltung der Erfindung enthält die analoge Schaltung einen induktiven Übertrager.

In einer Ausgestaltung der Erfindung wird bei der Umwandlung mindestens ein digitales Ausgangssignal erzeugt.

In einer Ausgestaltung der Erfindung wird das digitale Ausgangssignal unter Verwendung eines Analog Digital Wandlers, einer geeigneten Software und einer für die Software geeigneten Ausführungseinheit erzeugt.

In einer Ausgestaltung der Erfindung wird das digitale Ausgangssignal unter Verwendung eines Analog-Digital-Wandlers und einer geeigneten digitalen Schaltung erzeugt.

In einer Ausgestaltung der Erfindung bedient die Funktionseinheit 12 gleichzeitig auch die Datenverbindung 11.

In einer Ausgestaltung der Erfindung können Anwender mit der Funktionseinheit 12 auf die Verbrauchswerte und die Leistungswerte der Teilnetze die an den Modulen 10 angeschlossen sind zugreifen.

In einer Ausgestaltung der Erfindung senden die Module 10 Daten zu den einzelnen Teilnetzen über die Datenverbindung 11 an die Funktionseinheit 12.

In einer Ausgestaltung der Erfindung stellen die Module 10 auf der Datenverbindung 11 Funktionen zum Abholen der Daten zu den einzelnen Teilnetzen zur Verfügung.

In einer Ausgestaltung der Erfindung ist die Funktionseinheit 12 mit weiteren Geräten in einem Datennetzwerk verbunden.

In einer Ausgestaltung der Erfindung sind die Funktionen der Messspannungsversorgung und der Kommunikation in getrennten Geräten angeordnet.

### Bezugszeichenliste

- 1: Strommessmodul eines Strommesssystems entsprechend dem Stand der Technik
- 2: Leiter der Teilnetze, die durch die Strommessmodule 1 bzw. Module 10 geführt werden, mit ihren jeweiligen Strömen
- 3: Verbraucher
- 4: Stromsensor
- 5: Reiheneinbaugerät
- 6: Kommunikationsverbindung eines Strommesssystems entsprechend dem Stand der Technik
- 7: zentrale Funktionseinheit eines Strommesssystems entsprechend dem Stand der Technik
- 10: Modul des Leistungsmesssystems entsprechend der Erfindung
- 11: Datenverbindung des Leistungsmesssystems entsprechend der Erfindung
- 12: Funktionseinheit des Leistungsmesssystems entsprechend der Erfindung
- 13: Messmittel zur Umwandlung einer Niederspannung (z.B. 240V) in ein für die Messspannungsversorgung 15 geeignetes Signal
- 14: Niederspannung (z.B. 240V)
- 15: Messspannungsversorgung
- 16: Spannungseingang am Modul 10
- 20: Prozessor
- 21: Analog-Digital-Wandler
- 32: Messshunt
- 33: Spannungswandler
- 40: Phasen des Niederspannungsnetz
- 42: Stromschiene
- 43: Leitungsschutzschalter als spezielle Variante eines Reiheneinbaugerätes 5
- I: Strom in einem Leiter 2
- S_{U}: Spannungssignal für eine abgeleitete Spannung in der Messspannungsversorgung 14

## Patentansprüche

1. Erfassungssystem für Leistungen oder Energiemengen, die durch Leiter (2) übertragen werden, welche an einem Niederspannungsverteiler angeschlossen sind, umfassend:
zwei Module (10), wobei jedes Modul (10) ausgestaltet ist, eine Anzahl von Strömen (I) zu bestimmen, die durch eine Anzahl von Leitern (2) fließen, wobei die Anzahl von Leitern (2) an eine Anzahl von Reiheneinbaugeräten (5), die in dem Niederspannungsverteiler angeordnet sind, angeschlossen ist, und unter Verwendung eines bereitgestellten Signals (Su), das aus mindestens einer Eingangsspannung (14) auf Niederspannungsniveau erzeugt wird, Signale zu erzeugen, die repräsentativ für die Leistungen oder die Energiemengen sind, die jeweils durch die Anzahl von Leitern (2) übertragen werden, wobei jedes Modul (10) ausgestaltet ist, in dem Niederspannungsverteiler angeordnet zu werden, und zwar in Längsrichtung, insbesondere unmittelbar oberhalb oder unterhalb, der Anzahl von Reiheneinbaugeräten (5), und
zumindest eine Funktionseinheit (12), wobei die Funktionseinheit (12) ausgestaltet ist, zumindest ein Signal (Su), das anhand einer eineindeutigen Abbildungsvorschrift aus mindestens einer Eingangsspannung (14) auf Niederspannungsniveau erzeugt wird, zumindest einem Modul (10) bereitzustellen, und von jedem Modul (10) Signale zu empfangen, die repräsentativ für die Leistungen oder Energiemengen sind,
wobei eine Datenverbindung (11) und eine Messspannungsversorgung (15) vorgesehen sind, welche die Funktionseinheit (12) und jedes Modul (10) miteinander verbinden,
wobei die Datenverbindung (11) eine Busstruktur darstellt,
**dadurch gekennzeichnet, dass**
die Datenverbindung (11) und die Messspannungsversorgung (15) ganz über Flachbandkabel realisiert ist und die Datenverbindung (11) als durchgehendes Flachbandkabel realisiert ist und
die Übertragung zwischen der Funktionseinheit (12) und jedem Modul (10) eine definierte, konstante Latenzzeit zur Synchronisation aufweist.

2. Erfassungssystem nach Anspruch 1, wobei die Bereitstellung des zumindest einen Signals auf einer Messspannungsversorgung (15) über eine analoge Leitung oder über eine digitale Schnittstelle erfolgt.

3. Erfassungssystem nach Anspruch 1 oder 2, wobei in jedem Modul (10) jedem gemessenen Strom (I) ein Signal (Su) von mehreren möglichen Spannungen zugeordnet ist.

4. Erfassungssystem nach Anspruch 3, wobei die Zuordnung des Signals (Su) aus mehreren möglichen Spannungen durch eine Einstellung in Software in jedem Modul (10) oder anhand eines Algorithmus automatisch oder durch eine elektromechanische Kontaktherstellung manuell erfolgt.

5. Erfassungssystem nach einem der Ansprüche 1 bis 4, wobei in jeweils einem Modul (10) nur ein Signal (Su) aus mehreren möglichen Spannungen für alle Leiter (2), für das Modul (10) die jeweilige Leistung bestimmt, ausgewählt werden kann.

6. Erfassungssystem nach einem der Ansprüche 1 bis 5, wobei die Funktionseinheit (12) allen Modulen (10) ein und dasselbe Signal (S_{U})) bereitstellt.

7. Erfassungssystem nach einem der Ansprüche 1 bis 6, wobei die Eingangsspannung (14) von zumindest einem der Phasenanschlüsse (40) des Niederspannungsnetzes abgeleitet wird.

8. Erfassungssystem nach einem der Ansprüche 1 bis 7, wobei ein über einen induktiven Übertrager oder über einen Widerstandsspannungsteiler ein zur Eingangsspannung (14) proportionales Kleinspannungssignal erzeugt wird, aus welchem das Signal (Su) abgeleitet wird.

9. Erfassungssystem nach einem der vorherigen Ansprüche, wobei jedes Modul (10) so dimensioniert ist, dass es im Wesentlichen der Breite der entsprechenden Anzahl von Reiheneinbaugeräten (5) in Montageposition im Niederspannungsverteiler entspricht.

10. Erfassungssystem nach einem der vorherigen Ansprüche, wobei die Anzahl von Leitern (2) und die Anzahl von Reiheneinbaugeräten (5) jeweils eins ist.

11. Erfassungssystem nach einem der Ansprüche 1 bis 9, wobei die Anzahl von Leitern (2) und die Anzahl von Reiheneinbaugeräten (5) jeweils größer eins ist.

12. Erfassungssystem nach einem der vorherigen Ansprüche, **dadurch gekennzeichnet dass** die Funktionseinheit (12) eine Schnittstelle zur Verfügung stellt, über die Daten der Module (10) zu den Leistungen oder Energiemengen, die durch die Leiter (2) übertragen werden abgerufen und/oder analysiert werden können.

## Claims

1. A system for the detection of power or energy amounts transmitted through conductors (2) which are connected to a low-voltage distribution box, the system comprising:
two modules (10), each module (10) being configured to determine a number of currents (I) flowing through a number of conductors (2), the number of conductors (2) being connected to a number of modular DIN rail components (5) arranged within the low-voltage distribution box, and being further configured to create signals representative of the power or energy amounts which are transmitted through each of the number of conductors (2) by using a provided signal (Su) created at a low-voltage level from at least one input voltage (14), each module (10) being configured to be arranged within the low-voltage distribution box in a longitudinal direction, in particular immediately above or below the number of modular DIN rail components (5), and
at least one functional unit (12), said functional unit (12) being configured to provide a module (10) with at least one signal (Su) which is generated at a low-voltage level from at least one input voltage (14) on the basis of an unambiguous, one-to-one mapping instruction and to receive, from every module (10), signals that are representative of the power or energy amounts,
a data connection line (11) and a measuring voltage supply line (15) being provided to interconnect the functional unit (12) and each module (10),
said data connection line (11) being a bus structure,
**characterised in that**
the data connection line (11) and the measuring voltage supply line (15) are entirely realised by means of ribbon cables and the data connection line (11) is realised as a continuous ribbon cable, and
the transmission between the functional unit (12) and each module (10) has a defined, constant latency period for synchronisation.

2. The detection system as claimed in claim 1, wherein the at least one signal is provided on a measuring voltage supply line (15) via an analogue line or via a digital interface.

3. The detection system as claimed in claim 1 or 2, wherein in each module (10) a signal (Su) from among various possible voltages is associated with each measured current (I).

4. The detection system as claimed in claim 3, wherein the association of the signal (Su) from among several possible voltages is effected automatically by means of a setting in the software of each module (10) or by means of an algorithm, or is done manually by establishing an electromechanical contact.

5. The detection system as claimed in any one of claims 1 to 4, wherein in each specific module (10) only one signal (Su) can be selected from among several possible voltages for all conductors (2) for which module (10) determines the respective power.

6. The detection system as claimed in any one of claims 1 to 5, wherein the functional unit (12) provides all modules (10) with the very same signal (Su).

7. The detection system as claimed in any one of claims 1 to 6, wherein the input voltage (14) is drawn from at least one of the phase terminals (40) of the low voltage network.

8. The detection system as claimed in any one of claims 1 to 7, wherein an extra-low voltage signal which is proportional to the input voltage (14) is created via an inductive transmitter or via a resistor voltage divider and the signal (Su) is derived therefrom.

9. The detection system as claimed in any of the preceding claims, wherein each module (10) is dimensioned so as to correspond essentially to the width of the corresponding number of modular DIN rail components (5) in their mounting position within the low-voltage distribution box.

10. The detection system as claimed in any of the preceding claims, wherein the number of conductors (2) and the number of modular DIN rail components (5) is respectively equal to one.

11. The detection system as claimed in any one of claims 1 to 9, wherein the number of conductors (2) and the number of modular DIN rail components (5) is respectively greater than one.

12. The detection system as claimed in any of the preceding claims, **characterised in that** the functional unit (12) provides an interface via which data of the modules (10) concerning the power or energy amounts transmitted through said conductors (2) can be retrieved and/or analysed.

## Revendications

1. Système destiné à saisir des puissances ou des quantités d'énergie transmises par des conducteurs (2) qui sont connectés à un distributeur basse tension, ledit système comprenant :
deux modules (10), chaque module (10) étant conçu pour déterminer un nombre donné de courants (I) qui passent dans un nombre donné de conducteurs (2), le nombre donné de conducteurs (2) étant connecté à un nombre donné d'appareils modulaires série (5) lesquels sont disposés dans le distributeur basse tension et pour générer, en utilisant un signal (Su) fourni qui est généré à partir d'au moins une tension d'entrée (14) à un niveau basse tension, des signaux qui sont représentatifs pour les puissances ou les quantités d'énergie respectivement transmises par le nombre donné de conducteurs (2), chaque module (10) étant conçu pour être disposé dans le distributeur basse tension, et ce en sens longitudinal, en particulier directement au-dessus ou au-dessous du nombre donné d'appareils modulaires série (5), et
au moins une unité fonctionnelle (12), ladite unité fonctionnelle (12) étant conçue pour fournir à au moins un module (10) au moins un signal (Su) généré à l'aide d'une règle d'application biunivoque à partir d'au moins une tension d'entrée (14) à un niveau basse tension et pour recevoir de chaque module (10) des signaux qui sont représentatifs des puissances ou quantités d'énergie,
une liaison de données (11) et une alimentation en tension de mesure (15) étant prévues, lesquelles relient l'unité fonctionnelle (12) et chaque module (10),
la liaison de données (11) représentant une structure bus, **caractérisé en ce que**
la liaison de données (11) et l'alimentation en tension de mesure (15) sont réalisées entièrement par câbles rubans et que la liaison de données (11) est réalisée en tant que câble ruban continu et
la transmission entre l'unité fonctionnelle (12) et chaque module (10) présente un temps de latence constant défini destiné à la synchronisation.

2. Système de saisie selon la revendication 1, dans lequel la fourniture dudit au moins un signal sur une alimentation en tension de mesure (15) est réalisée par l'intermédiaire d'une ligne analogue ou d'une interface numérique.

3. Système de saisie selon la revendication 1 ou 2, dans lequel dans chaque module (10) est attribué à chaque courant mesuré (I) un signal (Su) pouvant être obtenu à partir de plusieurs tensions possibles.

4. Système de saisie selon la revendication 3, dans lequel l'attribution du signal (Su) obtenu à partir de plusieurs tensions possibles est réalisée de manière automatique par un réglage dans le logiciel de chaque module (10) ou à l'aide d'un algorithme ou de manière manuelle par une mise en contact électromécanique.

5. Système de saisie selon l'une quelconque des revendications 1 à 4, dans lequel un seul et unique signal (Su) obtenu à partir de plusieurs tensions possibles peut être sélectionné, dans respectivement un module (10) donné, pour tous les conducteurs (2) pour lesquels ledit module (10) détermine la puissance respective.

6. Système de saisie selon l'une quelconque des revendications 1 à 5, dans lequel l'unité fonctionnelle (12) fournit à tous les modules (10) un seul et même signal (Su).

7. Système de saisie selon l'une quelconque des revendications 1 à 6, dans lequel la tension d'entrée (14) est prise à au moins une des bornes de phase (40) du réseau basse tension.

8. Système de saisie selon l'une quelconque des revendications 1 à 7, dans lequel par l'intermédiaire d'un transformateur inductif ou d'un diviseur de tension à résistance est généré un signal très basse tension proportionnel à la tension d'entrée (14) à partir duquel est dérivé le signal (Su).

9. Système de saisie selon l'une quelconque des revendications précédentes, dans lequel chaque module (10) est dimensionné de telle sorte qu'il correspond essentiellement à la largeur du nombre correspondant d'appareils modulaires série (5) en position de montage dans le distributeur basse tension.

10. Système de saisie selon l'une quelconque des revendications précédentes, dans lequel le nombre de conducteurs (2) et le nombre d'appareils modulaires série (5) sont respectivement égaux à un.

11. Système de saisie selon l'une quelconque des revendications 1 à 9, dans lequel le nombre de conducteurs (2) et le nombre d'appareils modulaires série (5) sont respectivement supérieurs à un.

12. Système de saisie selon l'une quelconque des revendications précédentes, **caractérisé en ce que** l'unité fonctionnelle (12) fournit une interface grâce à laquelle peuvent être appelées et/ou analysées des données des modules (10) relatives aux puissances ou aux quantités d'énergie qui sont transmises par les conducteurs (2).
